(19) Europäisches Patentamt
European Patent Office
Office européen des brevets

(11) **EP 4 538 794 A1**

(12) **EUROPEAN PATENT APPLICATION**

(43) Date of publication:
**16.04.2025 Bulletin 2025/16**

(21) Application number: **23203390.2**

(22) Date of filing: **13.10.2023**

(51) International Patent Classification (IPC):
**G03F 7/00** $^{(2006.01)}$      **H01L 21/66** $^{(2006.01)}$

(52) Cooperative Patent Classification (CPC):
**G03F 7/70633; G03F 7/705; G03F 7/70616; H01L 22/12**

---

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
- **BUIJNSTERS, Frank, Jaco
  5500 AH Veldhoven (NL)**
- **SCHOUTROP, Chris
  5500 AH Veldhoven (NL)**

(74) Representative: **ASML Netherlands B.V.
Corporate Intellectual Property
P.O. Box 324
5500 AH Veldhoven (NL)**

---

(54) **METROLOGY METHOD AND ASSOCIATED METROLOGY DEVICE**

(57)      Disclosed is a method of identifying a source of a reconstruction error relating to reconstruction of a plurality of model parameters describing a structure on a substrate formed in a lithographic process. The method comprises: obtaining model parameters describing a nominal profile for describing said structure; obtaining metrology data relating to a measurement of said structure; determining simulated data, from a simulation of the measurement of said structure described in accordance with said model parameters; determining a spatially resolved sensitivity metric describing a sensitivity of a cost function to at least one property and/or function of said structure, said cost function comparing the metrology data and simulated data; and identifying a source of a reconstruction error from said spatially resolved sensitivity metric.

$$p_{i(\text{geom})} \xrightarrow{\boxed{\text{S1+S2}}} \Pi_l(x,y,z)$$
$$p_{i(\text{disp})} \xrightarrow{\text{disp mod}} n(\lambda), k(\lambda) \Bigg\} \xrightarrow{\boxed{\text{S2}}} \varepsilon_r(x,y,z;\ \lambda_k) = \sum_l [n(\lambda_k) + ik(\lambda_k)]^2\, \Pi_l(x,y,z)$$

$$\xrightarrow{\boxed{\text{S3a}}} C_\varepsilon, M_\varepsilon \xrightarrow{\boxed{\text{S3b}}} r_j(\lambda_k) \xrightarrow{\boxed{\text{S4}}} I_{\text{sim}}$$
$$\left. \begin{array}{c} I_{\text{meas}} \\ p_i \end{array} \right\} \xrightarrow{\text{ev } C} C$$
$$(\text{reg: })$$

**Fig. 8**

**Description**

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k1 lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

Present reconstruction techniques, to reconstruct parameters of a structure being measured, are mathematically and computationally complex due to the number of permutations of parameters to be varied. To address this, at least in the context of overlay metrology, other overlay measurement techniques have been developed which do not require reconstruction, e.g., those based on measurements of asymmetry of targets, which are typically biased to separate the overlay asymmetry from other asymmetries.

It would be desirable to improve on such reconstruction techniques and/or overlay metrology techniques.

SUMMARY

In a first aspect of the invention, there is provided a method of identifying a source of a reconstruction error relating to reconstruction of a plurality of model parameters describing a structure on a substrate formed in a lithographic process; the method comprising: obtaining model parameters describing a nominal profile for describing said structure; obtaining metrology data relating to a measurement of said structure; determining simulated data, from a simulation of the measurement of said structure described in accordance with said model parameters; determining a spatially resolved sensitivity metric describing a sensitivity of a cost function to at least one property and/or function of said structure, said cost function comparing the metrology data and simulated data; and identifying a source of a reconstruction error from said spatially resolved sensitivity metric.

According to a second aspect of the present invention there is provided a method of reconstructing a plurality of model parameters describing a structure on a substrate formed by a lithographic process; the method comprising: obtaining model parameters describing a nominal profile for describing said structure; obtaining metrology data relating to a measurement of said structure; determining simulated data, from a simulation of a measurement of said structure described in accordance with said model parameters; determining a spatially resolved sensitivity metric describing a sensitivity of a cost function to at least one property and/or function of said structure, said cost function comparing the metrology data and simulated data; determining derivatives of the cost function in geometric parameters of said plurality of model parameters from said spatially resolved sensitivity metric; and using said derivatives of the cost function in geometric parameters to evaluate said cost function and/or decide for which parameters the cost function should be next evaluated.

Other aspects comprise a computer program product containing one or more sequences of machine-readable instructions for implementing calculating steps in a method according to the first aspect or second aspect of the invention as set forth above.

The invention yet further provides a processing arrangement and metrology device comprising the computer program of the second aspect.

These and other aspects and advantages of the apparatus and methods disclosed herein will be appreciated from a consideration of the following description and drawings of exemplary embodiments.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;

- Figure 6 depicts a schematic representation of a metrology apparatus in which EUV and/or SXR radiation is used;
- Figure 7 depicts a simplified schematic drawing of an illumination source; and
- Figure 8 is a flow diagram describing an example reconstruction method.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

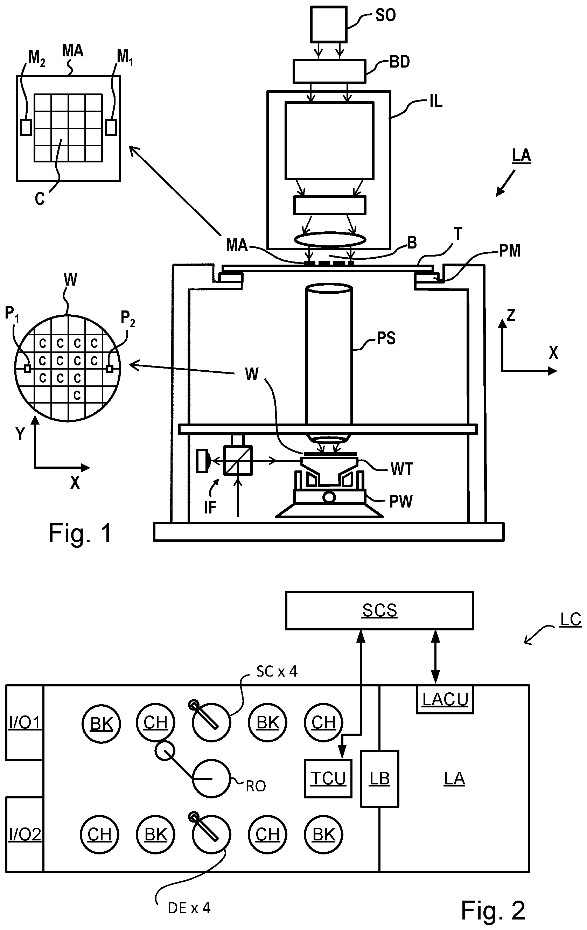

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

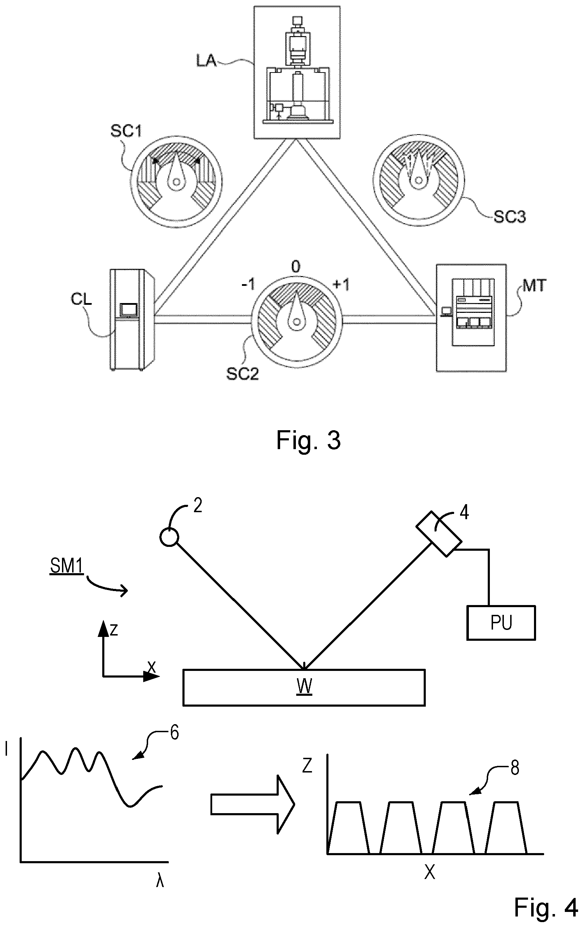

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

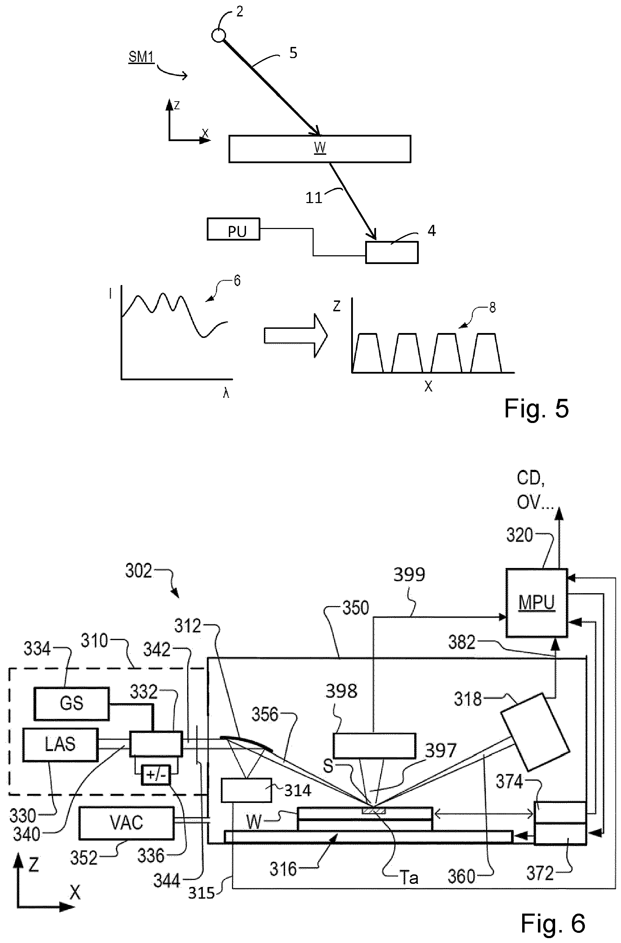

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019/003988A1, and in U.S. Patent Publication No. 2019/215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to $10\mu m$, for example in the region of 1 $\mu m$ (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 20 nm, 1nm to 20nm or 10nm to 20nm), a source may use High Harmonic Generation (HHG) or any other types of sources mentioned above to obtain radiation at the desired wavelength(s).

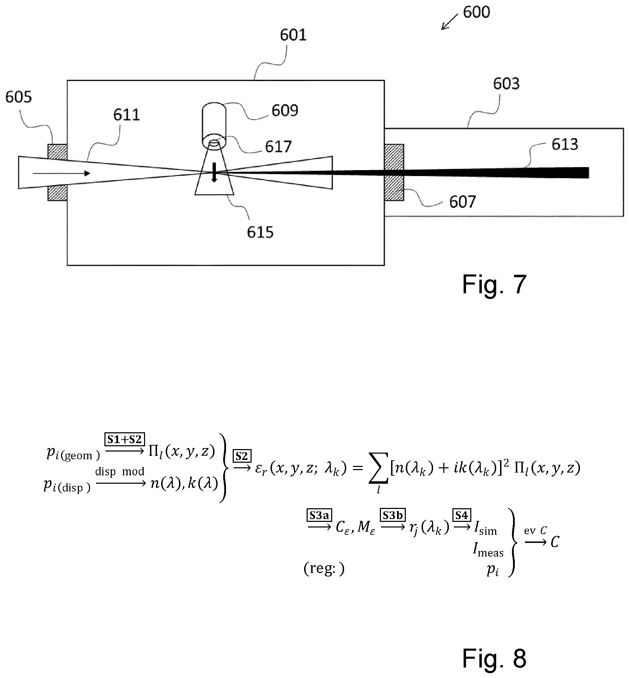

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, hereafter referred to as SXR radiation, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Profile metrology and reconstruction may be performed as part of a metrology process, to reconstruct geometric and/or material properties of a stack/structure based on a measurement/measurements of the stack. A profile reconstruction loop can be described as a non-linear optimization process where the model parameters (may referred as parameter in the following texts), e.g. geometric and material parameters $p_i$ (e.g., overlay, CD, tilt, and any nuisance parameters in each of the relevant layers of the stack) of a structure are inferred by minimization of a cost function $C(p_1, \ldots , p_n)$, which penalizes the mismatch between a simulated measurement (e.g., a simulated image), for a model realization for given parameters $p_i$, and the measured image (fidelity term), e.g., a measured image as may be captured on a detector or camera. The cost function may also include a "prior" or regularization term, which penalizes the *a priori* negative likelihood of the given combination of parameters. In the end, the specific combination of parameters $p_i$ which minimizes this cost function is reported back as the measured parameters (e.g., overlay, CD, tilt, etc.): they represent the most likely "true value" given the information contained in the measured image.

An SXR metrology tool such as has been described provides measurements with a high information content, due to the short wavelength used (high resolution). It is typical that the measurement fidelity term of the cost function $C$ does not go to zero even at its global minimum, resulting in a residual difference (also called residual, reconstruction error, or residual error) between the fitted forward model and the measured sensor image. Typical sources of this residual difference include:

- Incorrect assumptions / restrictions on the parameters ("fixing" parameters that should be "floated"); too strong priors; incorrect parameterization.
- Insufficient parameters to capture the actual deformations present in the stack.
- Incorrect assumptions on the material parameters / dispersion curves (inaccurate $n(\lambda)$, $k(\lambda)$ values).
- Structural errors in profile setup: some shapes or details are missing, layers are flipped, gratings are flipped.
- Sensor calibration errors.
- Camera noise.

It may be difficult to determine the source of the error from the residual vector alone. In practice, it can help to vary the set of fixed / floating parameters, and algorithms can be devised to do this in a more systematic way. For example via a "fix/float advisor" or more systematically, via an $L_1$ regularization term added to an $L_2$ data fidelity cost function. However algorithms presently used for profile metrology (e.g., CD reconstruction) cannot detect geometric deformations / degrees of freedom that are not parameterized, nor structural issues (mistakes) in the profile setup (layer swaps / incorrect materials / missing features etc.). The high complexity of typical stacks make it very likely that issues such as these occur during profile setup, even when detailed stack geometry data are made available.

Because of its high resolution, the SXR camera image comprises a lot of information on the stack. This opens the possibility of measuring many parameters at the same time, and, at least in theory, to distinguish different potential sources of error from each other. This is different from optical metrology using longer wavelengths (e.g., visible), where only a small subset of parameters can be measured and most parameters are strongly correlated to each other. However, it must be appreciated that while the methods are described herein in the context of SXR metrology, the methods are more generally applicable to other metrology methods including those which use other wavelengths (e.g., X-ray, visible and/or (near) infrared). The methods are applicable, in particular, to metrology methods which use multiple or broadband wavelengths, where more information is provided.

Another issue is that, if any type of "structural" issue is suspected, a traditional CD reconstruction approach would require retention of the interpolation library model constructed for the stack. This is a process that may take many hours on a large computer cluster for visible wavelength metrology, and may require much more computational resources still for a full SXR model which has a much higher information content. The cost of building a full reconstruction library also makes it harder to implement techniques previously applied to present CD reconstruction to determine the correct priors for features that are parameterized in the stack model.

Running multiple reconstructions using slightly different models, or a very careful comparison to cross section or TEM (transmissive electron microscope)/ SEM (scanning electron microscope) images (if available), might enable an experienced engineer to work out many common issues in the stack profile setup. However, it is likely that a lot of guesswork and "trial-and-error" would still be involved. A visual (spatial) representation of the source(s) of the residual error(s) would help point directly to the location of any error, and therefore to considerably narrow down the search space of issues. This would make it easier to detect any mistaken assumptions on the behavior of the stack profile. However, such a visual feedback is currently unavailable.

Methods are therefore described which provide such visual feedback, e.g., in terms of spatially resolved residual data.

The electromagnetic (EM) solver takes a specific geometric model as input, the model comprising, for example, sets of polygons that represent the cross sections of each material in the stack on a set of vertical sample points. Then it computes the Fourier coefficients of the relative permittivity function $\varepsilon_r(x, y, z)$ per $z$-sample point from these polygons, using the material properties for a given incident wavelength $\lambda$. It then computes the complex reflection coefficients of the stack for the given functions $\varepsilon_r(x, y, z)$ by numerically solving a discretized version of Maxwell's equations. The reflection coefficients computed by the EM solver, for every wavelength $\lambda$, are then fed into a model of the SXR sensor, which computes predicted camera intensity values. The norm of the difference between the predicted and measured images may then be used to compute the cost function $C$, which serves as the objective function which may be minimized in a reconstruction loop.

The efficient minimization of the cost function C typically involves some form of local gradient descent or conjugate gradient optimization. Each iteration of the optimization algorithm (reconstruction loop) requires at least one gradient evaluation. Thus, such a method may compute the gradient $\left(\frac{\partial C}{\partial p_i}\right)_i$ of the cost function in parameter space.

The evaluation of the cost function and its gradients involves solving Maxwell's equations for a range of wavelengths and parameter variations. In an on-the-fly reconstruction algorithm, these EM solves are performed within the optimization loop using a computer cluster. In this way, a first result is obtained in the shortest time and all parameters available may be varied within the model. An alternative approach, which involves building, off-line, a full interpolation model of the EM response of the stack for all relevant parameters prior to starting reconstruction. The model can then be used on-line, but is inconvenient to use in the critical set-up phase (time-to-recipe) and for the inevitable recipe updates. In addition, interpolation library construction faces some challenges specific to the context of SXR metrology compared to traditional optical metrology (CD reconstruction). It is therefore highly likely that a fast on-the-fly reconstruction loop will continue to be used alongside an interpolated model.

The problem of reconstruction for the SXR tool can be described as a non-convex optimization problem. The short wavelength results in a high sensitivity but also in a complex cost function landscape, with multiple local minima in each direction. In a current best-practice implementation, an initial global search is performed within a limited set of parameters, to arrive at the correct "basin" containing the global minimum. After that, a gradient-descent or conjugate-gradient type optimization may be performed to determine the global minimum of the cost function on the full set of parameters. In the present disclosure, steps to improve the local (all-parameter) optimization step will also be described. Such a method may use fast approximate models in the global search phase to get sufficiently close to the global minimum. However, the proposed concepts can be applied equally to the global search phase.

Figure 8 summarizes a method of reconstruction using a cost function C to minimize a difference between a simulated image $I_{sim}$ and a measured image $I_{meas}$. In this diagram, each arrow represents a function taking the output of the previous step to the input of the next step. The expensive part of the evaluation of the cost function is the computation of a simulated image $I_{sim}$ from the geometric parameters $p_{i(geom)}$, $i = 1, \ldots, n$, as defined in steps S1-S4.

The index $i = 1, \ldots, n$ represents a geometric parameter (or a material property); $l = 1, \ldots, N_{materials}$ indexes the materials in the stack; $k = 1, \ldots, N_{wavelengths}$ indexes the wavelengths that are present in the computation; and $j = 1, \ldots, m$ represents the index of an outgoing diffraction order. The number $N_{wavelengths}$ represents the number of discretization points used to describe the continuum wavelength range, and should be taken large enough such that all essential behavior in this range is captured. For the SXR tool, which uses a broadband source, this number is relatively large, $k \sim 100$. For SXR even a small relative change in wavelength can give a large deviation in the phase and amplitude of the reflection due to the small wavelength over stack height ratio.

This computation a simulated image $I_{sim}$ from the geometric parameters $p_{i(geom)}$ may be carried out in four main computational steps:

> S1. construction of a specific geometric model (e.g., in the form of polytope shapes, a mesh, or a volumetric description) from the geometric parameters $p_{i(geom)}$. In addition, a dispersion model (disp mod) may be used to determine $n(\lambda)$, $k(\lambda)$ from dispersion parameters $p_{i(disp)}$.
> S2. computation of the electrical permittivity function $\varepsilon(x, y, z)$, defined in all space, from these geometric shapes and the optical properties of each material in the stack (which may also be parameterized), for each relevant wavelength. This step may firstly comprise determining a (wavelength-independent) indicator function $\Pi_l(x, y, z)$ which describes which parts of space are occupied by material $l$. It may be assumed that $\Pi_l(x, y, z)$ takes the value 1 inside the region occupied by material $l$ and 0 outside that region;
> S3. solving Maxwell's equations for this specific permittivity function, for a prescribed incident beam; computing from it the complex reflection amplitudes $r_1, \ldots, r_m$, for all $m$ outgoing channels;
> S4. evaluation of simulated image (camera intensities) from the set of complex reflection amplitudes $\{r_m\}$, taking any sensor calibration data into account.

Solving Maxwell's equations (step S3) usually dominates the computational cost of the parameter reconstruction algorithm. Nevertheless the first two steps S1, S2 are also expensive steps, because the basic geometric input is resolved; modeling the process steps of the stack, and resolving any overlaps between shapes or process effects, after which all the matrix elements for all basis functions are evaluated.

It is useful to further subdivide step S3 into two parts, as shown in Figure 8:

- **S3a)** the initialization phase of the Maxwell solver, where matrices are computed that define the electromagnetic scattering problem given the electrical permittivity function describing the stack geometry. In particular, in one formulation of the Maxwell solver (for example as described in US patents US11041816, US8731882 and US8645109 incorporated herein by reference), matrices $C_\varepsilon$, $M_\varepsilon$ are computed, describing each of the z-discretization points $z_i$, from the Fourier coefficients of the function $\varepsilon(x, y, z_i)$ and its inverse $\varepsilon^{-1}(x, y, z_i)$.
- **S3b)** the linear solve phase of the Maxwell solver, where the linear system resulting from the discretized volume integral equation containing, in particular, the matrices obtained in step S3a is defined and solved. This typically uses an iterative solution method, and a post-processing step to obtain the reflection coefficients $r_j$.

Following step S4, the cost function is evaluated ev C to compare the simulated image $I_{sim}$ to a measured image simulated image $I_{meas}$. Parameters $p_i$ may also be provided that this evaluation stage for regularization reg.

There are multiple ways for computing the gradients. In a first gradient calculation method, a finite-differencing algorithm may be performed across the full flow. In other words, the cost function of the present iterate $C_0 = C(p_1, \ldots, p_n)$, and for each of the n possible perturbations, i.e., $C_1 = C(p_1 + \Delta, p_2, \ldots, p_n)$, $C_2 = C(p_1, p_2 + \Delta, \ldots, p_n)$, $\ldots$, $C_3 = C(p_1, p_2, \ldots, p_n + \Delta)$ may be computed. The final gradient may then be approximated by $\left(\frac{\partial C}{\partial p_i}\right)_i \approx \frac{C_i - C_0}{\Delta}$. This flow requires $n + 1$ expensive full forward calculations (and hence $(n + 1) \times N_{wavelengths}$ EM solves) per evaluation of the gradient.

In an alternative or second gradient calculation method, the structure of the EM solve (step S3) may be used to speed up the calculation of the gradient for situations where many geometry derivatives are needed. Such an approach may use the fact that the EM solver internally computes the reflection coefficients by evaluating an expression of the form $r_j = v_j^\dagger A_\varepsilon^{-1} u$, where u is a vector representing the incident beam, $v_j^\dagger$ is an adjoint vector representing the far-field projector of the mode, and $A_\varepsilon$ is a matrix discretizing the volume integral equation of the system. All quantities depend implicitly on wavelength $\lambda$ and the vectors typically have a dimension of $10^4$ - $10^5$ unknowns. The part dominating the computation time for the forward (non-derivative) evaluation of this expression is the linear solve implicit in the matrix inverse; i.e., finding $x$ such that $A_\varepsilon x = u$. For the derivative computation, it is observed that:

$$\frac{\partial r_j}{\partial p_i} = v_j^\dagger \frac{\partial A_\varepsilon^{-1}}{\partial p_i} u = -\left(A_\varepsilon^{-\dagger} v_j\right)^\dagger \frac{\partial A_\varepsilon}{\partial p_i} \left(A_\varepsilon^{-1} u\right), \qquad (1)$$

where, for simplicity, it is assumed that u and $v_j^\dagger$ do not depend on the geometric properties $p_i$. The vectors

$\tilde{u} := A_\varepsilon^{-1} u$ and $\tilde{v}_j^\dagger := \left(A_\varepsilon^{-\dagger} v_j\right)^\dagger$ for all orders $j$ may be precomputed, which takes a total of m + 1 linear solves (per wavelength). Once these vectors are computed, any particular parameter derivative $\frac{\partial r_j}{\partial p_i}$ may be evaluated without the need for solving any additional linear systems, using the dot product expression $\frac{\partial r_j}{\partial p_i} = \tilde{v}_j^\dagger \frac{\partial A_\varepsilon}{\partial p_i} \tilde{u}$. In other words, for each geometric parameter considered, steps S1+S2 of the computation flow are performed, followed by evaluating the matrix-vector product $A_\varepsilon^{-1} u$, and evaluating some dot products, which is typically much cheaper than performing a full EM solve.

In summary, with the existing methods, evaluating all parameter gradients $\partial r_j / \partial p_j$ for all $N_{\text{wavelengths}}$ wavelengths $\lambda_k$ requires a computation time of, for the first gradient calculation method: $(n + 1) \times N_{\text{wavelengths}} \times$ (initialization time + solve time) and for the second gradient calculation method: $(m + 1) \times N_{\text{wavelengths}} \times$ solve time + $(n + 1) \times N_{\text{wavelengths}} \times$ initialization time. Thus, the second gradient calculation method may be preferred in the case that the number of diffraction orders m is smaller than the number of geometric parameters n.

For the local (gradient-based, many-parameter) optimization loop, a single iteration is very costly, though the runtime can be reduced by executing the $(n + 1) \times k$ solves in a parallelized fashion. The current run-time for "on-the-fly" reconstruction for a single measurement is approximately 24 hours on a reasonable computer cluster, which is too long for a fast learning and evaluation cycle during recipe set-up (leading to a very long time-to-recipe). This would also limit use of the on-the-fly reconstruction loop to implement a dense recipe update cycle, and is infeasible for real-time reconstruction.

A key issue which lies at the root of the very long computation time of the baseline SXR reconstruction loop, is that, for both methods presented in the state of the art, an expensive initialization operation is required for each combination of a geometric parameter and a wavelength. Hence, the contribution of this operation to the total computational cost scales as $O(N_{\text{wavelengths}} \times n)$, which becomes the dominant contribution for typical values of $N_{\text{wavelengths}}$ and n. In addition, the naive backpropagation approach described in the second method above introduces a scaling proportional to the number of diffraction orders m, which considerably limits the benefit of such a method.

As such, the disclosure herein also describes a computational flow for backpropagation to optical contrast variations. Such a method may fully eliminate the term in the computational complexity which scales as $O(N_{\text{wavelengths}} \times n)$ where $n$ is the number of parameters. The resulting speed increase may be approximately 80x for stack profiles typically considered in the SXR reconstruction application.

As such, in this disclosure, an optimization in the reconstruction loop is proposed which reduces the on-the-fly reconstruction time by enabling, in particular, (much) faster gradient computations. Here, it is assumed that the model (and its set of floating parameters) is a given. Also disclosed is a method to provide direct and specific visual feedback on which parts of the model may be correct or incorrect, and which parameters may need to be added to reduce the residual further. This can be done using some intermediate quantities, with some implications also for efficient interpolation library construction. Although these two concepts are connected, they may also be implemented separately.

Firstly, some optimizations to the gradient computation will be described. These are valuable in themselves, but also lead to a method of backpropagation to permittivity variations (contrasts), enabling spatially resolved residuals to be determined and used as a diagnostic tool for recipe creation and profile reconstruction.

The methods proposed herein have the additional benefit that the dependence on the number of orders m disappears from the computational complexity. Some of the optimizations are relevant to any application where the iterative solve time per geometry perturbation is no longer a computational bottleneck, and apply equally to the low-order Born approximation proposed for a "global search" phase and to the fast backpropagation, which is the main focus here.

One embodiment is a method of backpropagation of cost function gradient in reflectivities for all outgoing channels simultaneously.

Existing gradient computational methods, such as those described above, result in an explicit evaluation of all $n \times m$ derivatives $\partial r_j / \partial p_j$. However, in practice only the n derivatives $\frac{\partial C}{\partial p_i}$ (gradient) of the cost function are of interest, which may be rewritten as $\frac{\partial C}{\partial p_i} = \sum_j \frac{\partial C}{\partial r_j} \frac{\partial r_j}{\partial p_i}$ (product rule). In other words, it is sufficient to evaluate only this specific linear combination of the derivatives $\dfrac{\partial r_j}{\partial p_i}$. Substituting Eq. (1), this can be written as:

$$\frac{\partial C}{\partial p_i} = \sum_j \frac{\partial C}{\partial r_j} \frac{\partial r_j}{\partial p_i} = \sum_j \frac{\partial C}{\partial r_j} v_j^\dagger \frac{\partial A_\varepsilon^{-1}}{\partial p_i} u = -\left[ A_\varepsilon^{-\dagger} \left( \sum_j \frac{\partial C}{\partial r_j} v_j \right) \right]^\dagger \frac{\partial A_\varepsilon}{\partial p_i} (A_\varepsilon^{-1} u) =: -\tilde{v}_C \frac{\partial A_\varepsilon}{\partial p_i} \tilde{u}. \quad (2)$$

In order to obtain the gradient of C in the parameters $p_i$, the vectors $\tilde{v}_c$ and $\tilde{u}$ may be computed, comprising two linear solves. Subsequently, the derivative for each parameter may be evaluated without any additional linear solves (only initialization time). In other words, a parameter derivative of reflectivity gradients may be evaluated for any given linear combination of outgoing channels $\sum_j \alpha_j \dfrac{\partial r_j}{\partial p_i}$ as efficiently as for a single specific outgoing channel. As a result, only two linear solves are required per wavelength for the full gradient calculation, instead of $m + 1$ solves.

In summary, evaluating all parameter derivatives $\partial r/\partial p_j$ for all $N_{\text{wavelengths}}$ wavelengths now requires a computation time of $2 \times N_{\text{wavelengths}} \times$ solve time $+ (n + 1) \times N_{\text{wavelengths}} \times$ initialization time.

It is remarked that only a single adjoint solve per wavelength is sufficient for all outgoing channels in the calculation. In the context of this disclosure, different "channels" refer to different outgoing diffraction orders and/or outgoing polarization directions. If there are two relevant polarization directions per diffraction order, the gradient of the cost function with respect to both polarizations can be obtained in one step. If it is assumed that both polarization directions are solved for in the forward calculation, the additional cost for the adjoint solve is only one half of the cost of a forward solve, and the computational cost becomes:

$$\frac{3}{2} \times N_{\text{wavelengths}} \times \text{solve time} + (n + 1) \times N_{\text{wavelengths}} \times \text{initialization time}$$

It may be appreciated that this latter approach works for both polarized and unpolarized / partially polarized light.

In the special case that the incident light for each given wavelength is coherent (and hence polarized), the normal calculation can also be accelerated by a factor two, namely by computing for one incident polarization direction instead of two. This applies even if this polarization direction does not coincide with one of the traditional s,p or x,y linear polarization directions (e.g., for circularly polarized light) provided an adequate software interface is available. In that case, the total computation time reduces further to:

$$1 \times N_{\text{wavelengths}} \times \text{solve time} + (n + 1) \times N_{\text{wavelengths}} \times \text{initialization time}$$

where "solve time" (as before) refers to the CPU time needed to solve two polarization directions.

One embodiment is a method of reuse Fourier coefficients in initialization.

In an SXR application, it may be that only a single angle of incidence is considered, for many wavelengths (broadband source). With the method I just described, the number of EM solves (step S3b) is reduced to two per gradient and per wavelength, regardless of the number of perturbations considered. Also, due to the high resolution of SXR metrology, the number of geometric parameter variations to be considered to obtain a small residual of the model relative to the measurement may be large. However, steps S1, S2, and S3a are repeated for all n possible parameter variations (perturbations) in order to obtain the matrices $\dfrac{\partial A_\varepsilon}{\partial p_i}$. Thus, for large $n$, the initialization time becomes dominant over the linear solve. (For moderately complex stack profiles, the initialization CPU time for a single nominal stack already significantly exceeds the CPU time of the full iterative solve for both polarizations.)

It is observed that the dominant part of the initialization time is typically in the construction of the Fourier coefficients of the indicator functions $\Pi_l(x, y, z)$ from the geometric mesh model (part of step S2). The geometric parameters are not wavelength dependent and therefore only require to be calculated once. When computing for multiple wavelengths, this result may be reused, such that the electrical permittivity function $\varepsilon_r(x, y, z; \lambda_k)$, $\varepsilon_r^{-1}(x, y, z; \lambda_k)$ is computed for each wavelength $\lambda_k$ as a simple linear combination (summation over the materials). Since also step S1 needs to be performed only once for all wavelengths, this leaves step S3a (obtaining the matrices $C_\varepsilon, M_\varepsilon$) as the only step repeated for all wavelengths and all perturbations.

With this improvement, evaluating all parameter derivatives $\partial r/\partial p_j$ for all $N_{\text{wavelengths}}$ wavelengths $\lambda_k$ now requires a computation time of:

$2 \times N_{\text{wavelengths}} \times$ solve time $+ (n + 1) \times$ init: step 2 $+ (n + 1) \times N_{\text{wavelengths}} \times$ init: step 3a where init: step 2 is an initialization time of step 2 and init: step 3a is an initialization time of step 3a.

One embodiment is a method of backpropagation to $\Pi_l$ functions.

All approaches (I.)-(II.) describe accelerating the evaluation of derivatives $\frac{\partial C}{\partial p_i}$ via variants of the traditional adjoint framework; either, as in approach (I.), via a faster evaluation of $\frac{\partial C}{\partial p_i}$ for given perturbations of the linear system $\frac{\partial A_\varepsilon(\lambda)}{\partial p_i}$, or, as in approaches (II.), by a faster evaluation of the perturbations $\frac{\partial A_\varepsilon(\lambda)}{\partial p_i}$ for given geometric and material parameter variations. While this represents a very significant speed increase, it still leaves one operation whose computational complexity scales as the product of $N_{\text{wavelengths}}$ and the number of perturbations n. Specifically, the step S3a, comprising the construction of the wavelength-dependent matrices $C_\varepsilon$, $M_\varepsilon$ from the Fourier coefficients of the (inverse) permittivity function $\varepsilon_r(x, y, z; \lambda)$, $\varepsilon_r^{-1}(x, y, z; \lambda)$, are still repeated $n \times N_{\text{wavelengths}}$ times. It is expected that this part is equivalent to multiple iterations of the iterative solver.

In this optimization, it is proposed to restructure this method and take the backpropagation one step further back in the computational chain shown in Figure 8, namely to the level of the permittivity variations (contrasts). In this approach, firstly the derivatives of the cost function $C$ with respect to the Fourier coefficients of $\varepsilon_r(x, y, z; \lambda)$ and $\varepsilon_r^{-1}(x, y, z; \lambda)$ may be computed per wavelength. Then, a linear combination of the results over all $N_{\text{wavelengths}}$ calculations may be determined to obtain two quantities:

- the derivatives of the cost function C with respect to the Fourier coefficients of the indicator functions $\Pi_l$ for each material *l*; and
- the derivatives of the cost function $C$ with respect to the values of the dispersion curves $n_l(\lambda)$, $k_l(\lambda)$ at each of the $N_{\text{wavelengths}}$ sample points of $\lambda$, for each material *l*.

These quantities can be obtained by applying backpropagation to the Equation for $\varepsilon_r(x, y, z; \lambda_k)$ in Figure 8; i.e.:

$$\varepsilon_r(x, y, z; \lambda_k) = \sum_l [n(\lambda_k) + ik(\lambda_k)]^2 \, \Pi_l(x, y, z)$$

The contributions to the cost function derivative over all wavelengths may be determined to obtain a quantity that no longer depends on wavelength. The derivatives in the Fourier coefficients of the indicator function of material *l* can be interpreted as a discretized form of the functional derivative $\frac{\delta C}{\delta \Pi_l(x,y,z)}$ (one for each material *l*). Similarly, the derivatives of $C$ in the refractive index and extinction coefficient $n_l(\lambda)$, $k_l(\lambda)$, while computed independently for each wavelength $\lambda$, may be represented as functional derivatives $\frac{\delta C}{\delta n_l(\lambda)}, \frac{\delta C}{\delta k_l(\lambda)}$, which are wavelength-dependent but not spatially dependent (they do not depend on the Fourier coefficients of $\Pi_l$).

Having computed the functional derivatives $\frac{\delta C}{\delta \Pi_l(x,y,z)}$, the derivatives of the cost function in the geometric parameters may be evaluated directly from the perturbations of the Fourier coefficients in $\Pi_l$. Mathematically, this can be expressed as an integral:

$$\frac{\partial C}{\partial p_i} = \sum_{l=1}^{N_{\text{materials}}} \iiint \frac{\delta C}{\delta \Pi_l(x, y, z)} \frac{\partial \Pi_l(x, y, z)}{\partial p_i} \, \mathrm{d}x \mathrm{d}y \mathrm{d}z$$

The discretized version of this expression is cheap to evaluate numerically (it is basically a dot product), once the derivatives of $C$ in the Fourier coefficients of the indicator functions $\Pi_l$, and the Fourier coefficients of the indicator functions $\Pi_l$ for the nominal profile and all $n$ perturbations, have been computed. Analogously, the cost function gradient with respect to any parameters $p_i$ which affect the material properties $n_l(\lambda), k_l(\lambda)$ can be obtained cheaply from the pre-computed

derivatives $\dfrac{\delta C}{\delta n_i(\lambda)}, \dfrac{\delta C}{\delta k_i(\lambda)}$.

The approach described in this section could be applied either without the optimizations described in section III or with those optimizations. In the former case, a total computation time per gradient may be:

$$2 \times N_{\text{wavelengths}} \times \text{solve time} + (n + 1) \times \text{init: step 2} + 1 \times N_{\text{wavelengths}} \times \text{init: step 3a}$$

With the constant-NVF approximations, a computation time may be obtained of: $2 \times N_{\text{wavelengths}} \times$ solve time + 1 $\times$ init: step 2 + $n \times$ init: step 2 [small range] + 1 $\times$ $N_{\text{wavelengths}}^{\text{sampled}} \times \text{init}$ : step 3a + 1 $\times N_{\text{wavelengths}} \times$ init: step 3a [only last part]

Notice that the re-use of the Fourier coefficients (method II) is implicit in method IV. However, the fixed-NVF approaches (method III) still have an impact in that they reduce the range of Fourier coefficients of $\Pi_l$ that are computed for each perturbation, providing a speed increase in the case that many perturbations are needed or the profile has a high geometric complexity (especially if the solve time per wavelength can be reduced further). For both approaches, the computational cost has no term which scales as the product $n \times N_{\text{wavelengths}}$.

Additional optimizations could be achieved by tuning the solver accuracy of the adjoint calculation to the desired target accuracy within each iteration step. This is possible if an approximate Hessian matrix of the cost function is not computed using finite differencing on the gradients (as in the current PTIN solver, which implements a type of quasi-Newton method), but can be evaluated directly in a fair approximation. An additional speed-up can be obtained by starting the internal iterative solver using a previous local reconstruction solver iterate in the forward calculation. This is facilitated by the adjoint computations, where finite differencing is not applied on iterative solver results. Such approaches could reduce the total computation time by a factor 2-3x.

One embodiment is a method of using spatially resolved residuals as a diagnostic tool for SXR recipe creation and profile reconstruction.

As described above, it is possible to evaluate the sensor model "in reverse", and compute the gradient of the cost function in the reflection coefficients $r_i(\lambda)$ of a given wavelength $\lambda$, where $i$ indexes the outgoing channels (diffraction order and polarization). This computation can be implemented efficiently by a method of backpropagation. The backpropagation can be taken one step further to variations in the internal matrix representations $C_\varepsilon, M_\varepsilon$ in the solver. The backpropagation can be taken back another step further, to obtain the derivatives of the cost function $C$ with respect to the Fourier coefficients of the functions $\varepsilon_r(x, y, z)$ and $\varepsilon_r^{-1}(x, y, z)$, for a given wavelength $\lambda$. These computations can be carried out efficiently, and are comparable in computational cost to one iteration of the local reconstruction solver. While examples of this backpropagation are described above, it can be appreciated that the basic method and approach disclosed herein is not specific to any particular EM solver or any specific discretization scheme.

The method may comprise determining a spatially resolved sensitivity metric describing sensitivity of the cost function to a (wavelength dependent or wavelength independent) optical and/or material property (e.g., one or more of $\varepsilon_r(x, y, z; \lambda)$, $\delta k_i(\lambda)$ and $n_i(\lambda)$) of said structure, said cost function comparing metrology data (which relates to a measurement of said structure, optionally with a plurality of wavelengths) and simulated data (which is obtained from a simulation of the measurement of said structure described in accordance with said model parameters). The method may also comprise determining a spatially resolved sensitivity metric describing sensitivity of the cost function to the wavelength-independent shape function and/or fill fraction function of any material or set of materials (here denoted as the indicator function $\Pi_l(x, y, z)$) of said structure, said cost function comparing the metrology data and simulated data.

The result of this step is a quantity or spatially resolved sensitivity metric that can be interpreted as the (discretized version of a) functional derivative:

$$\frac{\delta C}{\delta \varepsilon_r(x, y, z; \lambda)}$$

This quantity is a function which describes the sensitivity (gradient) of the cost function to any small local change or perturbation in the optical contrast at a given point in space. Since the residual vector should be zero if the match is perfect, this quantity should give an indication as to where and to what extent the model assumptions are wrong. For example, this quantity is a function of the spatial coordinates $x, y, z$ (and wavelength), and is expected to have a larger magnitude (absolute value) near points $x, y, z$ where the difference between the reconstructed model and the physical stack that has been measured, is largest. Because the cost function $C$ is treated as a function of all possible contrast variations instead of the pre-defined geometric parameters (e.g., it does not explicitly depend on the stack parameters, but on the actual geometry), it will provide feedback on the source of any residual in the data fidelity term even if it cannot be captured by (is orthogonal to) any geometric perturbations described by the predefined set of parameters.

The functional derivative $\frac{\delta C}{\delta \varepsilon_r(x,y,z;\lambda)}$, obtained by backpropagation to the optical contrast, contains information on just a single wavelength (a fully coherent measurement). It is therefore expected that the residual at optical contrast level (for a single wavelength) will still show a high level of delocalization and long-range correlation, even information on multiple outgoing diffraction orders is combined. It is by combining the information from multiple wavelengths (which are incoherent from each other) that the SXR tool is able to achieve its high level of decorrelation between different parameters, and better resolve the vertical direction.

In order to integrate the information for the full wavelength range, a natural ansatz is employed in the contrast description of the stack, namely that the optical properties are a function of wavelength but are constant (homogeneous) within the space occupied by each separate material. Mathematically, it is assumed that the electrical permittivity function is given by:

$$\varepsilon_r(x, y, z;\ \lambda) = \sum_{l=1}^{N_{\text{materials}}} [n_l(\lambda) + ik_l(\lambda)]^2\ \Pi_l(x, y, z),$$

where $n_l(\lambda)$, $k_l(\lambda)$ are the refractive index and extinction coefficient (dispersion curves) of the material $l$ and $\Pi_l(x, y, z)$ is a wavelength-independent indicator function that describes which parts of space are occupied by material $l$. It may be assumed that $\Pi_l(x, y, z)$ takes the value 1 inside the region occupied by material $l$ and 0 outside that region. With this ansatz, a quantity or spatially resolved sensitivity metric may be defined that describes the sensitivity of the cost function to changes in the space (volume) occupied by material $l$:

$$\frac{\delta C}{\delta \Pi_l(x, y, z)}$$

This quantity is a function of the spatial coordinates $x, y, z$, and is expected to have a larger magnitude (absolute value) near points $x, y, z$ where the difference between the reconstructed model and the physical stack that has been measured, is largest. If a greater amount of a certain material $l$ is present in the stack near the given point $x, y, z$ according to the measurement than is accounted for in the reconstructed model, the function is likely to take a negative value; if it is less, the function is likely to take a positive value. A shift in the interface surface between material $l$ and material $l'$ could be detected by computing the difference $\frac{\delta C}{\delta \Pi_{l'}(x,y,z)} - \frac{\delta C}{\delta \Pi_l(x,y,z)}$, with a negative value meaning that the physical location of the interface surface of material $l'$ is shifted outward relative to its position in the reconstructed model, and a positive value inward.

Alongside this quantity, the following quantities or material sensitivity metrics which describe the sensitivity of the cost function to changes in the dispersion curves, may also be determined:

$$\frac{\delta C}{\delta n_l(\lambda)}, \frac{\delta C}{\delta k_l(\lambda)}$$

These quantities are not a function of space but a function of wavelength. These quantities may be used to detect any systematic error in the material properties assumed for each material. Materials $l$ whose measured material properties are very different from those assumed in the reconstructed model, are expected to give a function $\frac{\delta C}{\delta n_l(\lambda)}$ and/or $\frac{\delta C}{\delta k_l(\lambda)}$ with a large magnitude (absolute value). A positive sign of the function $\frac{\delta C}{\delta n_l(\lambda)}$ indicates that the true refractive index n of material $l$ is less near wavelength $\lambda$ than the value assumed in the reconstructed model, a negative sign indicates that it is greater; and analogously for $\frac{\delta C}{\delta k_l(\lambda)}$ and the extinction coefficient $k_l$.

As such, a method may comprise assessing the sensitivity metric to determine its magnitude per position and assume any position (location in space) is a source of a reconstruction error if it is significantly large, e.g., above a threshold. A type of error may be determined by its sign (e.g., for $\frac{\delta C}{\delta\Pi_l(x,y,z)}$, whether there is less or more of each material in the structure/stack, for the quantities $\frac{\delta C}{\delta n_l(\lambda)}$, $\frac{\delta C}{\delta k_l(\lambda)}$ whether an assumed value for the material property is too great or too small).

The method may also comprise assessing a spatially resolved sensitivity metric difference between the sensitivity metric for different materials. For example, the magnitude of such a difference may be assessed (e.g., against a threshold) to determine (e.g., if too large) whether a physical location of an interface between the two materials is incorrectly assumed in the nominal profile. The sign of the difference may be used to determine in which direction such an interface may be shifted.

It is possible to simultaneously implement backpropagation to any calibration parameters that the sensor model might contain. It may be assumed that an issue in (for example) the stack geometry definition (which is spatially localized) should be relatively easy to distinguish from a sensor calibration error, which should provide a more "global" / delocalized distortion in the spatially resolved residual function.

It can be appreciated that the quantity $\frac{\delta C}{\delta\Pi_l(x,y,z)}$ integrates information over all wavelengths at the same time. In practice, the long, coherent, oscillatory tails, which may be expected in the functional derivative with respect to the optical contrast for a single wavelength, should average out when integrating over all wavelengths as each wavelength brings with it a different "phase factor" throughout the stack. This means that the behavior of this quantity is expected to respond in a much more localized way to small perturbations than the contrast inversion for a single wavelength.

The backpropagation to indicator functions to obtain the "spatially resolved residual" can be implemented in computational time comparable to a single iteration of the local reconstruction solver. Moreover, the spatially resolved residual approach could be used in its own right to significantly speed up the usual reconstruction loop for the floating parameters that are explicitly defined for the stack model.

Note that it is still proposed to use a parameterized model to optimize for those parameters that are included in the model. Computing the spatially resolved residuals directly on the nominal profile may prove to be insufficient to obtain useful information, because of the complex cost function landscape with many local minima. A global search in at least the layer heights and other "structural" parameters may still be performed before computing the spatially resolved residuals.

Although the "on-the-fly" reconstruction appears tractable even in an HVM context, it is expected that some form of library interpolation might still be performed to speed up the computations. The "spatially resolved residual" method could be used, as a potential follow-up development, in a machine learning model, as a pre-processing stage on the signal. This would help the machine learning model to learn more efficiently the many "fine" parameters in the model, in particular if it is assumed that the "coarse" parameters such as layer thicknesses have already been reconstructed (which could be done using a smaller forward library model, on a subset of the floating parameters). Although this could be seen as a "linear transformation" on the signal (which is no easier or harder to train, for example, a dense neural network on, compared to the original signal), the spatially resolved residual signal would have the following benefits:

- The signals are expected to be localized to an area close to the spatial location of the parameter of interest. This would allow the defining of regularizing priors specifically enforcing localization of the features, and hence (further) improve decorrelation between parameters.
- A localized feature model would make the signal to consider for each feature smaller, potentially reducing the size (and cost of training) of the model.
- The weight functions of the "fine" features could be shifted according to the location of the geometric element that they are related to (as obtained from the reconstructed coarse model). This is a fundamentally non-linear operation that should help extend the range of validity of the fine model, potentially even to outside the (coarse) parameter range on which it was originally trained.

Further embodiments are disclosed in the subsequent numbered clauses:

1. A method of identifying a source of a reconstruction error relating to reconstruction of a plurality of model parameters describing a structure on a substrate formed in a lithographic process; the method comprising:

obtaining model parameters describing a nominal profile for describing said structure;
obtaining metrology data relating to a measurement of said structure;
determining simulated data, from a simulation of the measurement of said structure described in accordance with said model parameters;
determining a spatially resolved sensitivity metric describing a sensitivity of a cost function to at least one property and/or function of said structure, said cost function comparing the metrology data and simulated data; and

identifying a source of a reconstruction error from said spatially resolved sensitivity metric.

2. A method as claimed in clause 1, wherein said property and/or function of said structure comprises an optical property of said structure.

3. A method as claimed in clause 2, wherein said spatially resolved sensitivity metric describes sensitivity of the cost function to local contrast variation.

4. A method as claimed in clause 3, wherein said spatially resolved sensitivity metric is determined from derivatives of the cost function with respect to Fourier coefficients or other basis set coefficients of a permittivity function.

5. A method as claimed in clause 1, wherein said spatially resolved sensitivity metric describes sensitivity of the cost function to changes in volume occupied by each material of which said structure is comprised.

6. A method as claimed in clause 5, wherein said at least one optical property and/or material property is assumed to be homogeneous per volume occupied by each material.

7. A method as claimed in clause 5 or 6, wherein said optical property and/or material property comprises a geometric indicator function describing a shape function and/or fill fraction for any material or set of materials in said structure.

8. A method as claimed in any of clauses 5 to 7, wherein said spatially resolved sensitivity metric is determined from derivatives of the cost function with respect to Fourier coefficients or other basis set coefficients of per-material indicator functions which describes which portions of said volume are occupied by each said material.

9. A method as claimed in clause 8, comprising using a single evaluation of the Fourier coefficients or other basis set coefficients of the per-material indicator functions to evaluate the scattered field for a plurality of wavelengths.

10. A method as claimed in clause 7, 8 or 9, wherein information from multiple wavelengths is combined into a spatially resolved sensitivity metric which is independent of wavelength.

11. A method as claimed in any preceding clause, wherein said identifying a source of the reconstruction error comprises:

determining a magnitude of said spatially resolved sensitivity metric at one or more positions within said structure; and

determining said source of the reconstruction error from said magnitude of said spatially resolved sensitivity metric.

12. A method as claimed in clause 11, wherein said determining said source of the reconstruction error from said magnitude of said spatially resolved sensitivity metric comprises determining a source of reconstruction error as that for which a said magnitude of said spatially resolved sensitivity metric exceeds a threshold.

13. A method as claimed in clause 11 or 12, comprising determining a type of reconstruction error from the sign of said spatially resolved sensitivity metric.

14. A method as claimed in any preceding clause, comprising:

assessing a spatially resolved sensitivity metric difference between the spatially resolved sensitivity metric for respective different materials or sets of materials; and

assessing an assumed position for an interface between said respective different materials based on said difference.

15. A method as claimed in clause 14, comprising assessing the assumed position for the interface between said respective different materials based on a magnitude said difference.

16. A method as claimed in clause 14 or 15, comprising determining in which direction to shift the assumed position for the interface between said respective different materials based on a sign of said difference.

17. A method as claimed in any preceding clause, wherein said metrology data relates to the measurement of said structure with a plurality of wavelengths.

18. A method as claimed in any preceding clause, further comprising determining one or more material sensitivity metrics, wherein said one or more material sensitivity metrics comprise a material sensitivity metric describing the sensitivity of the cost function to changes in refractive index for each said material and a sensitivity metric describing the sensitivity of the cost function to changes in extinction coefficient for each said material.

19. A method as claimed in clause 18, wherein said identifying a source of the reconstruction error comprises:

determining a magnitude of said material sensitivity metric for each material; and

determining said source of the reconstruction error from said magnitude of said material sensitivity metric.

20. A method as claimed in clause 19, wherein said determining said source of the reconstruction error from said magnitude of said material sensitivity metric comprises determining a source of reconstruction error as that for which a said magnitude of said material sensitivity metric exceeds a threshold.

21. A method as claimed in clause 19 or 20, comprising determining whether the reconstruction error relates to an overestimation or underestimation of an assumed value for the relevant material property from the sign of said material sensitivity metric.

22. A method as claimed in any preceding clause, further comprising determining derivatives of the cost function in geometric parameters of said plurality of model parameters from said spatially resolved sensitivity metric.

23. A method as claimed in clause 22, comprising determining said derivatives of the cost function in geometric parameters from a product of said spatially resolved sensitivity metric and Fourier coefficients or other basis set coefficients of the indicator functions for the nominal profile and all perturbations, summed over all said materials.

24. A method as claimed in clause 22 or 23, comprising using said derivatives of the cost function in geometric parameters to find a minimum of said cost function.

25. A method as claimed in any preceding clause, comprising varying one or more of said plurality of parameters to minimize said cost function.

26. A method of reconstructing a plurality of model parameters describing a structure on a substrate formed by a lithographic process; the method comprising:

obtaining model parameters describing a nominal profile for describing said structure;
obtaining metrology data relating to a measurement of said structure;
determining simulated data, from a simulation of a measurement of said structure described in accordance with said model parameters;
determining a spatially resolved sensitivity metric describing a sensitivity of a cost function to at least one property and/or function of said structure, said cost function comparing the metrology data and simulated data;
determining derivatives of the cost function in geometric parameters of said plurality of model parameters from said spatially resolved sensitivity metric; and
using said derivatives of the cost function in geometric parameters to evaluate said cost function and/or decide for which parameters the cost function should be next evaluated.

27. A method as claimed in clause 26, wherein said property and/or function of said structure comprises an optical property of said structure.

28. A method as claimed in clause 27, wherein said spatially resolved sensitivity metric describes sensitivity of the cost function to local contrast variation.

29. A method as claimed in clause 28, wherein said spatially resolved sensitivity metric is determined from derivatives of the cost function with respect to Fourier coefficients of a permittivity function.

30. A method as claimed in clause 26, wherein said spatially resolved sensitivity metric describes sensitivity of the cost function to changes in volume occupied by each material of which said structure is comprised.

31. A method as claimed in clause 30, wherein said at least one optical property and/or material property is assumed to be homogeneous per volume occupied by each material.

32. A method as claimed in clause 30 or 31, wherein said optical property and/or material property comprises a geometric indicator function describing a shape function and/or fill fraction for any material or set of materials in said structure.

33. A method as claimed in clause 30, 31 or 32, wherein said spatially resolved sensitivity metric is determined from derivatives of the cost function with respect to Fourier coefficients or other basis set coefficients of per-material indicator functions which describes which portions of said volume are occupied by each said material.

34. A method as claimed in clause 33, comprising using a single evaluation of the Fourier coefficients or other basis set coefficients of the per-material indicator functions to evaluate the scattered field for a plurality of wavelengths.

35. A method as claimed in any of clauses 26 to 34, further comprising determining a sensitivity metric describing the sensitivity of the cost function to changes in refractive index for each said material and a sensitivity metric describing the sensitivity of the cost function to changes in extinction coefficient for each said material.

36. A method as claimed in clause 35, comprising determining said derivatives of the cost function in geometric parameters from a product of said spatially resolved sensitivity metric and Fourier coefficients of the indicator functions for the nominal profile and all perturbations, summed over all said materials.

37. A method as claimed in any of clauses 26 to 36, comprising varying one or more of said plurality of parameters to minimize said cost function.

38. A method as claimed in any of clauses 26 to 37, wherein said metrology data relates to the measurement of said structure with a plurality of wavelengths.

39. A method as claimed in clauses 26 to 38, wherein said spatially resolved sensitivity metric is fed into library model which uses the spatially resolved sensitivity metric to predict a forward response and/or estimate said model parameters based on said measurement data and/or a likely minimum of the cost function.

40. A method as claimed in clause 39, wherein said library model comprises a machine learning model.

41. A method as claimed in any preceding clause, comprising performing a measurement of said structure to obtain said metrology data.

42. A computer program comprising program instructions operable to perform the method of any preceding clause, when run on a suitable apparatus.

43. A non-transient computer program carrier comprising the computer program of clause 42.

44. A processing arrangement comprising:

a computer program carrier comprising the computer program of clause 43; and
a processor operable to run said computer program.

45. A metrology device comprising the processing arrangement of clause 44.

46. A metrology device being operable to perform the method as claimed in any of clauses 1 to 41.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

It should be appreciated that the term color is used throughout this text synonymously with wavelength or spectral component and the colors may include those outside the visible band (e.g., infrared or ultraviolet wavelengths).

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 1-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

1. A method of identifying a source of a reconstruction error relating to reconstruction of a plurality of model parameters describing a structure on a substrate formed in a lithographic process; the method comprising:

   obtaining model parameters describing a nominal profile for describing said structure;
   obtaining metrology data relating to a measurement of said structure;
   determining simulated data, from a simulation of the measurement of said structure described in accordance with said model parameters;
   determining a spatially resolved sensitivity metric describing a sensitivity of a cost function to at least one property and/or function of said structure, said cost function comparing the metrology data and simulated data; and
   identifying the source of the reconstruction error from said spatially resolved sensitivity metric.

2. A method as claimed in claim 1, wherein said property and/or function of said structure comprises an optical property of said structure.

3. A method as claimed in claim 2, wherein said spatially resolved sensitivity metric describes sensitivity of the cost function to local contrast variation.

4. A method as claimed in claim 1, wherein said spatially resolved sensitivity metric describes sensitivity of the cost function to changes in volume occupied by each material of which said structure is comprised.

5. A method as claimed in claim 4, wherein said optical property and/or material property comprises a geometric indicator function describing a shape function and/or fill fraction for any material or set of materials in said structure.

6. A method as claimed in any preceding claim, wherein information from multiple wavelengths is combined into a spatially resolved sensitivity metric which is independent of wavelength.

7. A method as claimed in any preceding claim, wherein said identifying a source of the reconstruction error comprises:

   determining a magnitude of said spatially resolved sensitivity metric at one or more positions within said structure; and
   determining said source of the reconstruction error from said magnitude of said spatially resolved sensitivity metric.

8. A method as claimed in claim 7, wherein said determining said source of the reconstruction error from said magnitude of said spatially resolved sensitivity metric comprises determining a source of reconstruction error as that for which a said magnitude of said spatially resolved sensitivity metric exceeds a threshold.

9. A method as claimed in any preceding claim, wherein said metrology data relates to the measurement of said structure with a plurality of wavelengths.

10. A method as claimed in any preceding claim, further comprising determining one or more material sensitivity metrics, wherein said one or more material sensitivity metrics comprise a material sensitivity metric describing the sensitivity of the cost function to changes in refractive index for each said material and a sensitivity metric describing the sensitivity of the cost function to changes in extinction coefficient for each said material.

11. A method as claimed in any preceding claim, comprising varying one or more of said plurality of parameters to minimize said cost function.

12. A method of reconstructing a plurality of model parameters describing a structure on a substrate formed by a lithographic process; the method comprising:

obtaining model parameters describing a nominal profile for describing said structure;
obtaining metrology data relating to a measurement of said structure;
determining simulated data, from a simulation of a measurement of said structure described in accordance with said model parameters;
determining a spatially resolved sensitivity metric describing a sensitivity of a cost function to at least one property and/or function of said structure, said cost function comparing the metrology data and simulated data;
determining derivatives of the cost function in geometric parameters of said plurality of model parameters from said spatially resolved sensitivity metric; and
using said derivatives of the cost function in geometric parameters to evaluate said cost function and/or decide for which parameters the cost function should be next evaluated.

13. A metrology apparatus comprising a controller, wherein the controller is configured to cause performance of the method as claimed in any of claims 1 to 12.

14. A non-transitory computer program product comprising machine-readable instructions therein, the instructions, upon execution by a computer system, configured to cause the computer system to at least cause performance of the method as claimed in any of claims 1 to 12.

15. A metrology device being operable to perform the method as claimed in any of claims 1 to 12.

Fig. 1

Fig. 2

Fig. 3

Fig. 4

Fig. 5

Fig. 6

Fig. 7

$$p_{i(\text{geom})} \xrightarrow{\boxed{\text{S1+S2}}} \Pi_l(x,y,z) \Bigg\} \quad \boxed{\text{S2}} \atop \xrightarrow{\phantom{x}} \varepsilon_r(x,y,z;\ \lambda_k) = \sum_l [n(\lambda_k) + ik(\lambda_k)]^2\ \Pi_l(x,y,z)$$

$$p_{i(\text{disp})} \xrightarrow{\text{disp mod}} n(\lambda), k(\lambda) \Bigg.$$

$$\xrightarrow{\boxed{\text{S3a}}} C_\varepsilon, M_\varepsilon \xrightarrow{\boxed{\text{S3b}}} r_j(\lambda_k) \xrightarrow{\boxed{\text{S4}}} I_{\text{sim}} \atop I_{\text{meas}} \atop (\text{reg:}) \qquad\qquad\qquad\qquad p_i \Bigg\} \xrightarrow{\text{ev}\ C} C$$

Fig. 8

Europäisches
Patentamt

European
Patent Office

Office européen
des brevets

# EUROPEAN SEARCH REPORT

**Application Number**

EP 23 20 3390

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/171290 A1 (ONOSE ALEXANDRU [NL] ET AL) 2 June 2022 (2022-06-02) | 15 | INV.<br>G03F7/00 |
| A | * paragraphs [0004] - [0009] *<br>* paragraphs [0011] - [0012] *<br>* paragraphs [0060] - [0072]; figure 5 *<br>----- | 1-14 | H01L21/66 |
| X | US 2016/313658 A1 (MARCIANO TAL [IL] ET AL) 27 October 2016 (2016-10-27) | 15 | |
| A | * paragraph [0009] *<br>* paragraph [0034] *<br>* paragraphs [0047] - [0068] *<br>* paragraphs [0101] - [0102] *<br>* paragraphs [0122] - [0123] *<br>----- | 1-14 | |

**TECHNICAL FIELDS
SEARCHED     (IPC)**

G03F
H01L

The present search report has been drawn up for all claims

| Place of search | Date of completion of the search | Examiner |
|---|---|---|
| Munich | 25 March 2024 | van Toledo, Wiebo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 20 3390

25-03-2024

| Patent document cited in search report | Publication date | Patent family member(s) | Publication date |
|---|---|---|---|
| US 2022171290 A1 | 02-06-2022 | CN 113574458 A | 29-10-2021 |
| | | TW 202040265 A | 01-11-2020 |
| | | TW 202141175 A | 01-11-2021 |
| | | US 2022171290 A1 | 02-06-2022 |
| | | WO 2020182468 A1 | 17-09-2020 |
| US 2016313658 A1 | 27-10-2016 | CN 107078074 A | 18-08-2017 |
| | | CN 112698551 A | 23-04-2021 |
| | | JP 6770958 B2 | 21-10-2020 |
| | | JP 7023337 B2 | 21-02-2022 |
| | | JP 2017537317 A | 14-12-2017 |
| | | JP 2020201293 A | 17-12-2020 |
| | | JP 2022065040 A | 26-04-2022 |
| | | KR 20170088403 A | 01-08-2017 |
| | | SG 11201703585R A | 29-06-2017 |
| | | TW 201633419 A | 16-09-2016 |
| | | TW 202018836 A | 16-05-2020 |
| | | US 2016313658 A1 | 27-10-2016 |
| | | WO 2016086056 A1 | 02-06-2016 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B

- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- US 11041816 B
- US 8731882 B
- US 8645109 B

**Non-patent literature cited in the description**

- **LEMAILLET et al.** Intercomparison between optical and X-ray scatterometry measurements of FinFET structures. *Proc. of SPIE*, 2013, 8681